# EUROPEAN PATENT SPECIFICATION

(11) **EP 1 121 476 B1**
(45) Date of publication and mention of the grant of the patent: **16.11.2005**
(21) Application number: 00950949.8
(22) Date of filing: 03.08.2000
(51) Int. Cl.: C23C 14/46

(54) **ELECTRON BEAM PHYSICAL VAPOR DEPOSITION APPARATUS**
ELEKTRONSTRAHL-PVD-VORRICHTUNG
DISPOSITIF DE DEPOT PHYSIQUE EN PHASE VAPEUR A FAISCEAU D'ELECTRONS

(30) Priority: 04.08.1999 US 147231 P; 24.07.2000 US 621755
(43) Date of publication of application: 08.08.2001
(73) Proprietor: GENERAL ELECTRIC COMPANY, Schenectady, NY 12345 (US)
(72) Inventor: BRUCE, Robert, William, Loveland, OH 45140 (US); EVANS, John, Douglas, Sr., Springfield, OH 45502 (US); MARICOCCHI, Antonio, Frank, Loveland, OH 45140 (US); EBERHARDT, Helmut, D-63584 Grundau 3 (DE); RICK, Alfred, D-63791 Karlstein (DE); BAEHR, Martin, D-01465 Liegau-Augustusbad (DE); REITH, Wolfgang, Erhardt, D-63571 Gelnhausen (DE)
(74) Representative: Goode, Ian Roy
(86) International application number: PCT/US2000/021132
(87) International publication number: WO 2001/011107

(56) References cited:
- WO-A-86/02581
- GB-A- 1 089 967
- US-A- 4 885 070
- US-A- 5 637 199

## Description

### FIELD OF THE INVENTION

This invention generally relates to an electron beam physical vapor deposition coating apparatus. More particularly, this invention is directed to such a coating apparatus adapted to deposit ceramic coatings on components, such as thermal barrier coatings on superalloy components of gas turbine engines.

### BACKGROUND OF THE INVENTION

Higher operating temperatures for gas turbine engines are continuously sought in order to increase their efficiency. However, as operating temperatures increase, the high temperature durability of the components of the engine must correspondingly increase. While significant advances have been achieved with iron, nickel and cobalt-base superalloys, the high-temperature capabilities of these alloys alone are often inadequate for components located in certain sections of a gas turbine engine, such as the turbine, combustor and augmentor. A common solution is to thermally insulate such components in order to minimize their service temperatures. For this purpose, thermal barrier coatings (TBC) formed on the exposed surfaces of high temperature components have found wide use.

To be effective, thermal barrier coatings must have low thermal conductivity and adhere well to the component surface. Various ceramic materials have been employed as the TBC, particularly zirconia (ZrO₂) stabilized by yttria (Y₂O₃), magnesia (MgO) or other oxides. These particular materials are widely employed in the art because they can be readily deposited by plasma spray and vapor deposition techniques. An example of the latter is electron beam physical vapor deposition (EBPVD), which produces a thermal barrier coating having a columnar grain structure that is able to expand with its underlying substrate without causing damaging stresses that lead to spallation, and therefore exhibits enhanced strain tolerance. Adhesion of the TBC to the component is often further enhanced by the presence of a metallic bond coat, such as a diffusion aluminide or an oxidation-resistant alloy such as MCrAlY, where M is iron, cobalt and/or nickel.

Processes for producing TBC by EBPVD generally entail preheating a component to an acceptable coating temperature, and then inserting the component into a heated coating chamber. During coating, the component is supported in proximity to an ingot of the ceramic coating material (e.g., YSZ), and an electron beam generated by an electron beam (EB) gun is projected onto the ingot so as to melt the surface of the ingot and produce a vapor of the coating material that deposits onto the component. In the past, the coating chamber would be maintained at a pressure of about 0.005 mbar. Higher pressures were avoided because control of the electron beam is more difficult at pressures above about 0.005 mbar, with erratic operation being reported at coating chamber pressures above 0.010 mbar. It was also believed that the interior of the EB gun would become contaminated if operated with coating chamber pressures above 0.005 mbar, and that the life of the gun filament would be reduced.

According to copending US-A-6,447,854, assigned to the same assignee as the present invention, EBPVD coating pressures of greater than 0.010 mbar can be employed to produce TBCs with significantly improved spallation resistance and reduced thermal conductivity. Accordingly, it would be desirable if an improved EBPVD apparatus were available that reduced the risk of EB gun contamination and shortened gun filament life when operating the apparatus at coating pressures above 0.010 mbar in accordance with Rigney et al.

### BRIEF SUMMARY OF THE INVENTION

The present invention is an electron beam physical vapor deposition (EBPVD) apparatus in accordance with claim 1 thereof. The apparatus is for producing a coating (e.g., a ceramic thermal barrier coating) on an article. The EBPVD apparatus of this invention generally includes a coating chamber that is operable at an elevated temperature (e.g., at least 800°C) and a subatmospheric pressure, generally above 0.010 mbar. An electron beam gun is used to project an electron beam through an aperture in a wall of the coating chamber, and onto a coating material within a coating region defined within the chamber. The electron beam gun is operated to melt and evaporate the coating material. Also included is a device for supporting an article within the coating chamber so that vapors of the coating material can deposit on the article.

According to the present invention, the operation of the EBPVD apparatus at coating pressures above 0.010 mbar is enhanced by the inclusion within the coating chamber of a second chamber that encloses the aperture so as to separate the aperture from the coating region. Also provided is means for maintaining the second chamber at a pressure lower than the coating region. As a result, coating pressures of greater than 0.010 mbar can be practiced in accordance with US-A-6,447,854 with minimal or no adverse effects on the operation and reliability of the electron beam gun.

Other objects and advantages of this invention will be better appreciated from the following detailed description.

### BRIEF DESCRIPTION OF THE DRAWINGS

Figures 1 and 2 are schematic top and front views, respectively, of an electron beam physical vapor deposition apparatus used to deposit a coating material in accordance with this invention.
Figure 3 is a more detailed front cross-sectional view of interior components for the coating chamber of the apparatus of Figures 1 and 2, including a second chamber mounted to the upper wall of the coating chamber in accordance with this invention.

### DETAILED DESCRIPTION OF THE INVENTION

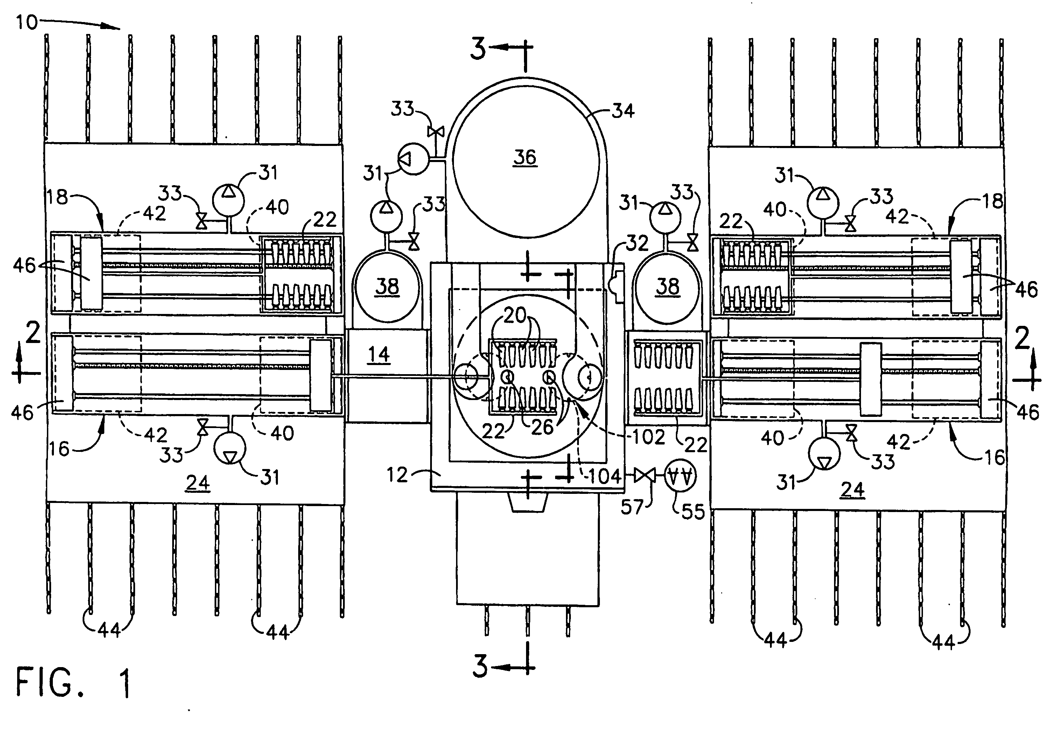

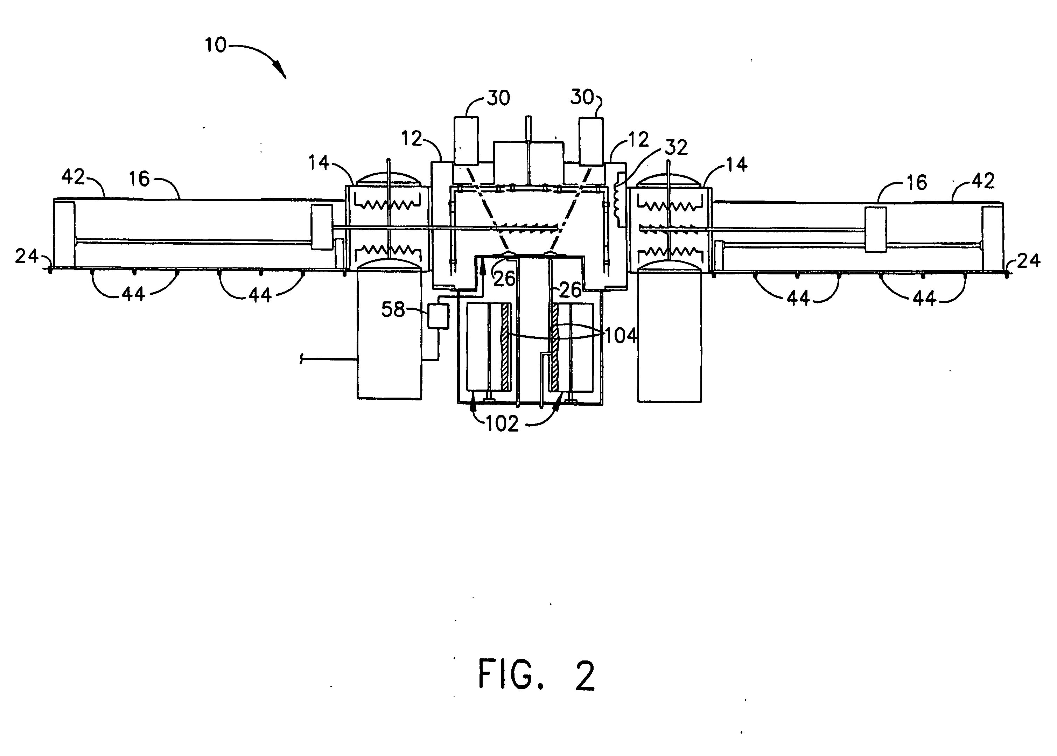

An EBPVD apparatus 10 in accordance with this invention is generally depicted in Figures 1 and 2. The apparatus 10 is particularly well suited for depositing a ceramic thermal barrier coating on a metal component intended for operation within a thermally hostile environment. Notable examples of such components include the high and low pressure turbine nozzles and blades, shrouds, combustor liners and augmentor hardware of gas turbine engines. While the advantages of this invention will be described with reference to depositing a ceramic coating on such components, the teachings of this invention can be generally applied to a variety of coating materials and components.

For purposes of illustrating the invention, the EBPVD apparatus 10 is shown in Figures 1 and 2 as including a coating chamber 12, a pair of preheat chambers 14, and two pairs of loading chambers 16 and 18, so that the apparatus 10 has a symmetrical configuration. Ingots 26 of the desired coating material are shown as being fed by elevators 61 into the coating chamber 12 from channels 104 of a magazine 102 located beneath the coating chamber 12. Clamping arms 60 are used to secure the evaporating ingots 26 in place. The front loading chambers 16 are shown as being aligned with their preheat chambers 14, with parts 20 originally loaded on a rake 22 within the lefthand loading chamber 16 having been transferred to the lefthand preheat chamber 14 and, as depicted in Figure 1, into the coating chamber 12. With the symmetrical configuration of the apparatus 10, while the parts 20 loaded through the front lefthand loading chamber 16 are being coated within the coating chamber 12, a second batch of parts in the front righthand loading chamber 16 can be preheated in the righthand preheat chamber 14, a third batch of parts can be loaded into the rear lefthand loading chamber 18, and a fourth batch of parts can be unloaded from the rear righthand loading chamber 18. Consequently, four process stages can occur simultaneously with the preferred EBPVD apparatus 10 of this invention.

According to a preferred aspect of this invention, the loading chambers 16 and 18 are mounted to low-profile movable platforms 24, so that the loading chambers 16 and 18 can be selectively aligned with their preheat chambers 14. Each platform 24 is also preferably movable to a maintenance position, in which neither of the loading chambers 16 and 18 is aligned with its preheat chamber 14, so that the interiors of the preheat and loading chambers 14, 16 and 18 can be accessed for cleaning. The platforms 24 are preferably at least in part supported on roller bearings 44 mounted in the floor, though it is foreseeable that a variety of bearings could be used. The platforms 24 preferably have a low elevational profile (projection above the floor) of not more than about one inch (about 2.5 cm), with a chamfered edge, which together essentially eliminate the potential for an operator tripping on the edge of the platform 24. Stationary objects surrounding the apparatus 10 are preferably positioned away from the edges of the platforms 24 to avoid an operator being pinched by a platform 24 when it is repositioned.

The loading chambers 16 and 18 are generally elongate in shape, and are equipped with loading doors 40 through which parts are loaded onto the rakes 22. The loading chambers 16 and 18 are also equipped with access doors 42 to motion drives (schematically represented at 46 in Figure 1) that control the operation of the rakes 22. More particularly, the parts 20 supported on the rakes 22 are preferably rotated and/or oscillated within the coating chamber 12 in order to promote the desired coating distribution around the parts 20. The access doors 42 allow the operator of the apparatus 10 to quickly adjust or change the settings of the motion drives 46 without interfering with loading and unloading of parts from the loading chambers 16 and 18.

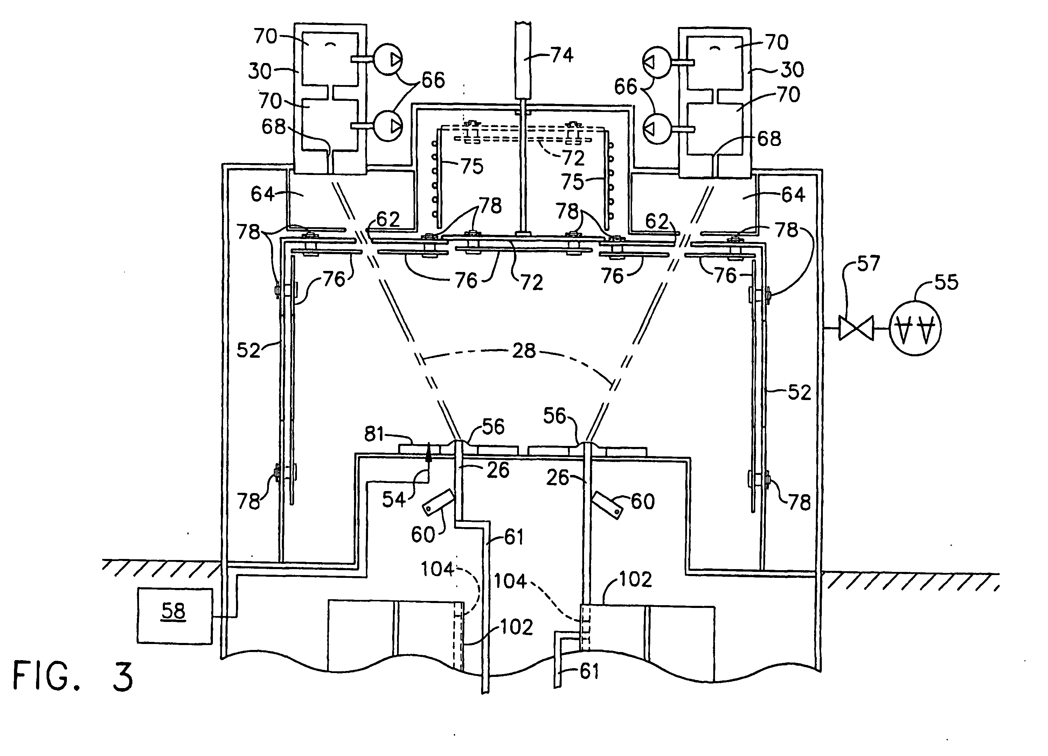

With reference to Figure 3, coating is performed within the coating chamber 12 by melting and evaporating the ingots 26 with electron beams 28 that are produced by electron beam (EB) guns 30 and focused on the ingots 26. Intense heating of the ceramic material by the electron beams 28 causes the surface of each ingot 26 to melt, forming molten ceramic pools from which molecules of the ceramic material evaporate, travel upwardly, and then deposit on the surfaces of the parts 20, producing the desired ceramic coating whose thickness will depend on the duration of the coating process. While two ingots 26 are shown in Figure 3, it is within the scope of this invention that one or more ingots 26 could be present and simultaneously evaporated.

As also seen in Figure 3, oxygen and argon gases are introduced into the coating chamber 12 through an inlet 54 located near crucibles 56 that support the ingots 26 within the coating chamber 12 and retain the molten pools of ceramic material produced by the electron beams 28. The flow rates of oxygen and argon are individually controlled based on the targeted process pressure and oxygen partial pressure. To reduce the occurrence of pressure oscillations within the coating chamber 12, the control loop response time for these gases is preferably reduced by physically placing the control valves 58 for the gases adjacent the inlet 54 outside the coating chamber 12. Placement of the control valves 58 so close to the coating chamber 12 provides a surprisingly significant improvement in pressure control, reducing pressure fluctuations within the coating chamber 12 and reducing disturbances in the focus and position of the electron beams 28 on the ingots 26.

After rough pumpdown with mechanical pumps 31, cryogenic and diffusion pumps 32 and 34 of types known in the art can be employed to evacuate the coating chamber 12 prior to the deposition process. A separate pair of diffusion pumps 38 is shown as being employed to evacuate the preheat chamber 14. As indicated in Figure 1, the diffusion pump 34 for the coating chamber 12 may be modified with a throttle valve 36 to regulate the operation of the pump 34 at relatively high pressures, e.g., above 0.010 mbar, which are preferred by this invention as discussed below. The diffusion pumps 38 for the preheat chambers 14 are also preferably equipped with throttle valves for the same purpose.

EBPVD coating chambers are typically capable of being maintained at a vacuum level of about 0.001 mbar (about 1x10⁻³ Torr) or less. In the prior art, a vacuum of at most 0.010 mbar, and more typically about 0.005 mbar, would be drawn within the coating chamber 12 during the coating process, the reason being that higher pressures were known to cause erratic operation of the EB guns 30 and make the electron beams 28 difficult to control, with the presumption that inferior coatings would result. It has also been believed that the life of the gun filament would be reduced or the gun contaminated if operated at coating chamber pressures above 0.005 mbar. However, in accordance with US-A-6,447,854, the coating chamber 12 is preferably operated at higher pressures that surprisingly yield a ceramic coating with improved spallation and impact resistance, as well as promote the coating deposition rate in conjunction with higher ingot evaporation rates than that achieved in the prior art.

In order to address the aforementioned problems concerning the control of the electron beams 28 and protection of the EB guns 30 at the higher coating pressures employed by this invention, the EB guns 30 are relatively isolated from the higher coating pressure within the coating chamber 12. In Figure 3, a condensate hood 52 is shown that catches most of the superfluous ceramic vapors that do not deposit onto the parts 20. The hood 52 is configured according to this invention to define a coating region around the parts 20, within which the elevated pressure desired for the coating process is specifically maintained. To facilitate cleaning between coating campaigns, the hood 52 is preferably equipped with screens 76 that can be removed and cleaned outside of the coating chamber 12. Preferably, the screens 76 are retained by spring pins 78 instead of threaded fasteners in order to simplify removal of the screens 76 when in the condition of having been coated with a layer of the coating material by the end of a campaign.

Because the hood 52 surrounds the parts 20 as seen in Figure 3, an aperture 62 is necessary for each beam 28 through the hood 52. To promote the capability of maintaining higher pressures within the condensate hood 52 as compared to the remainder of the coating chamber 12, including the vicinity around the EB guns 30, the apertures 62 are preferably formed to have dimensions of not more than that necessary to allow the beams 28 to pass through the hood 52. For this purpose, the apertures 62 are preferably cut with the beams 28 during the initial setup of the EBPVD apparatus 10.

According to this invention, in order to more reliably isolate the EB guns 30 from the elevated pressure within the coating region defined by the condensate hood 52, the beams 28 travel from their respective guns 30 through chambers 64 formed between the interior walls of the coating chamber 12 and the condensate hood 52. As shown in Figure 3, each of the chambers 64 is preferably formed by an upper wall of the coating chamber 12 and side walls attached to the upper wall of the coating chamber 12. In Figure 3, the lower end of each chamber 64 is shown as being closed by a wall parallel to the wall of the condensate hood 52 in which the apertures 62 are formed, though this wall of the hood 52 could also serve to enclose the lower ends of the chambers 64. The hood 52 is preferably unattached to the walls of the chambers 64. In this manner, the condensate hood 52 can be moved within the coating chamber 12 without requiring physical detachment of the chambers 64 from the coating chamber 12.

The diffusion pump 34 preferably has an inlet near and pneumatically coupled to each of the chambers 64. Because of the minimum size of the apertures 62, the elevated pressure within the condensate hood 52 (achieved with the introduction of oxygen and argon with the inlet 54) bleeds into the chambers 64 at a sufficiently reduced rate to enable the diffusion pump 34 to maintain the chambers 64 at a pressure lower than that within the condensate hood 52.

During the coating operation, the electron beams 28 are focused on the ingots 26, thereby forming the molten pools of ceramic and vapors that deposit on the parts 20. While various coating materials could be used, a preferred ceramic material for TBC (and therefore the ingots 26) is zirconia (ZrO₂) partially or fully stabilized by yttria (e.g., 3%-20%, preferably 4%-8% Y₂O₃), though yttria stabilized with magnesia, ceria, calcia, scandia or other oxides could be used. The coating operation continues until the desired thickness for the coating on the parts 20 is obtained, after which the parts 20 are transferred through the preheat chamber 14 to the loading chamber 16, at which time the loading chamber 16 is vented to atmosphere.

While our invention has been described in terms of a preferred embodiment, it is apparent that other forms could be adopted by one skilled in the art. Accordingly, the scope of our invention is to be limited only by the following claims.

## Claims

1. An electron beam physical vapor deposition coating apparatus (10) comprising:
a coating chamber (12);
a hood (52) defining a coating region within the coating chamber (12), the coating region containing a coating material (26), the coating region being operable at an elevated temperature and a sub atmospheric pressure;
an electron beam gun (30) for projecting an electron beam (28) into the coating region and onto the coating material (26), the electron beam gun (30) being operable to melt the coating material (26) and to evaporate molten coating material (26);
means (22) for supporting an article (20) in the coating region so that vapors of the coating material (26) deposit on the article (20);
an aperture (68) in a wall of the coating chamber (12) through which the electron beam (28) enters the coating chamber (12);
a second chamber (64) within the coating chamber (12) and enclosing the aperture (68) so as to separate the aperture (68) from the coating region; and
a second aperture (62) through which the electron beam (28) exits the second chamber (64) and enters the coating region whereby the second chamber (64) is maintained at a pressure lower than the coating region **characterized by** the second chamber having a first wall portion attached to the wall of the coating chamber (12) and a second wall portion containing the second aperture (62) through which the electron beam exits which is unattached to the hood (52).

## Patentansprüche

1. Elektronenstrahl-PVD-Beschichtungseinrichtung (10):
mit einer Beschichtungskammer (12),
mit einer Haube (52), die innerhalb der Beschichtungskammer (12) einen Beschichtungsbereich festlegt, wobei der Beschichtungsbereich ein Beschichtungsmaterial (26) enthält und wobei der Beschichtungsbereich mit einer erhöhten Temperatur und subatmosphärischem Druck betreibbar ist,
mit einer Elektronenkanone (30), die einen Elektronenstrahl (28) in den Beschichtungsbereich und auf das Beschichtungsmaterial (26) richtet, wobei die Elektronenkanone (30) dazu eingerichtet ist, das Beschichtungsmaterial (26) zu schmelzen und das geschmolzene Beschichtungsmaterial (26) zu verdampfen,
mit einem Mittel (22) zum Halten eines Gegenstands (20) in dem Beschichtungsbereich, so dass sich Dämpfe des Beschichtungsmaterials (26) auf dem Gegenstand (20) niederschlagen,
mit einer Öffnung (68) in einer Wand der Beschichtungskammer (12), durch die der Elektronenstrahl (28) in die Beschichtungskammer (12) gelangt,
mit einer zweiten Kammer (64), die innerhalb der Beschichtungskammer (12) angeordnet ist und die Öffnung (68) einschließt, um die Öffnung (68) von dem Beschichtungsbereich zu trennen und
mit einer zweiten Öffnung (62), durch die der Elektronenstrahl (28) die zweite Kammer (64) verlässt und in den Beschichtungsbereich eintritt, wobei die zweite Kammer (64) auf einem Druck gehalten wird, der niedriger ist als in dem Beschichtungsbereich, **dadurch gekennzeichnet, dass** die zweite Kammer einen ersten Wandabschnitt aufweist, der an der Wand der Beschichtungskammer (12) befestigt ist, sowie einen zweiten Wandabschnitt, der die zweite Öffnung (62) enthält, durch die der Elektronenstrahl austritt, und der mit der Haube (52) nicht verbunden ist.

## Revendications

1. Dispositif de revêtement par dépôt physique en phase vapeur sous l'effet d'un faisceau d'électrons (10) comprenant :
une chambre de revêtement (12) ;
une hotte (52) définissant une région de revêtement à l'intérieur de la chambre de revêtement (12), la région de revêtement contenant un matériau de revêtement (26), la région de revêtement pouvant être activée à une température élevée et à une pression sous-atmosphérique ;
un canon à faisceau d'électrons (30) pour projeter un faisceau d'électrons (28) dans la région de revêtement et sur le matériau de revêtement (26), le canon à faisceau d'électrons (30) pouvant être utilisé pour faire fondre le matériau de revêtement (26) et pour évaporer le matériau de revêtement fondu (26) ;
un moyen (22) pour supporter un article (20) dans la région de revêtement de manière telle que les vapeurs de matériau de revêtement (26) se déposent sur l'article (20) ;
une ouverture (68) dans une paroi de la chambre de revêtement (12) par laquelle le faisceau d'électrons (28) entre dans la chambre de revêtement (12) ;
une deuxième chambre (64) à l'intérieur de la chambre de revêtement (12) et enfermant l'ouverture (68) afin de séparer l'ouverture (68) de la région de revêtement ; et
une deuxième ouverture (62) par laquelle le faisceau d'électrons (28) sort de la deuxième chambre (64) et entre dans la région de revêtement, la deuxième chambre (64) étant maintenue à une pression inférieure à la région de revêtement, **caractérisé en ce que** la deuxième chambre comporte une première partie de paroi fixée à la paroi de la chambre de revêtement (12) et une deuxième partie de paroi contenant la deuxième ouverture (62) par laquelle sort le faisceau d'électrons qui n'est pas fixée à la hotte (52).
